# EUROPÄISCHE PATENTSCHRIFT

(11) **EP 4 478 430 B1**
(45) Veröffentlichungstag und Bekanntmachung des Hinweises auf die Patenterteilung: **07.05.2025**
(21) Anmeldenummer: 24000070.3
(22) Anmeldetag: 07.06.2024
(51) Int. Cl.: H10F 10/142, H10F 77/20, H01L 21/48, H01L 23/498, B23K 26/384, B23K 26/402, B23K 103/16

(54) **VERFAHREN ZUR HERSTELLUNG EINES VIAS BEI EINER III-V MEHRFACHSOLARZELLE**
METHOD FOR PRODUCING A VIA IN A III-V MULTIJUNCTION SOLAR CELL
PROCÉDÉ DE FABRICATION D'UN TROU D'INTERCONNEXION DANS UNE CELLULE SOLAIRE MULTIPLE III-V

(30) Priorität: 14.06.2023 DE 102023002413
(43) Veröffentlichungstag der Anmeldung: 18.12.2024
(73) Patentinhaber: AZUR SPACE Solar Power GmbH, 74072 Heilbronn (DE)
(72) Erfinder: Sommer, Steffen, 71732 Tamm (DE); Köstler, Wolfgang, 74074 Heilbronn (DE)
(74) Vertreter: Koch Müller Patentanwaltsgesellschaft mbH

(56) Entgegenhaltungen:
- WO-A1-2015/032241
- DE-A1- 102019 006 091
- DE-A1- 102019 006 094
- DE-A1- 102019 008 106
- DE-T2- 69 216 502
- US-A1- 2006 231 130
- US-A1- 2018 337 299

## Beschreibung

Aus der DE 692 16 502 T2 ist ein Laserschneidverfahren zur Herstellung von Durchgangslöchern für Durchkontaktierungen bei GaAs bzw. Ge- Solarzellen bekannt, wobei mit dem offenbarten Verfahren u.a. Nachteile einer CVD SiO₂ Beschichtung bei Durchgangslöchern vermieden werden sollen.

In einem ersten Verfahrensschritt wird mittels von Laserpulsen eines YAG Lasers eine durchgehende Öffnung mit einem großen Durchmesser erzeugt, Um die bei dem Laserbeschuss entstehenden sehr rauen Oberflächen an den Seitenwänden der Durchgangsöffnung für eine spätere Metallisierung vorzubereiten, werden in einem zweiten Verfahrensschritt u.a. die Seitenwände mit einem Polyimid übergossen bzw. bei kleineren durchgehenden Öffnungen die Öffnung vollständig mit Polyimid gefüllt. In einem nachfolgenden Verfahrensschritt wird das Polyimid zum Aushärten erwärmt

Das Polyimid wird als dielektrische Beschichtung bezeichnet. In einem vierten Verfahrensschritt wird mittels des Lasers innerhalb des Polyimid ein Durchgangsloch mit einem kleinen Durchmesser erzeugt, wobei das Polyimid nach dem Laserbeschuss an den neu entstehenden Seitenflächen glatte Oberfläche aufweist. Die Polyimid Seitenflächen werden in einem nachfolgenden Verfahrensschritt mit einem Metall bedeckt.

Mit der Auftragung von Polyimid wird u.a. auch die Notwendigkeit, mittels einer aggressiven chemischen Ätzung die Seitenflächen zu glätten, vermieden und der aktive Bereich der Solarzelle und das GaAs-Substrat oder das Ge-Substrat vor dem Ätzangriff geschützt. Ferner weist das Polyimid eine gute Haftung sowohl zu dem Substrat als auch gegenüber einer aufzubringenden Durchführungsmetallisierung auf.

DE 10 2019 006094 A1 offenbart auch ein Laserschneidverfahren zur Herstellung von Durchgangslöchern für Durchkontaktierungen bei GaAs bzw. Ge- Solarzellen, wobei sich überlappende Öffnungen durch Fotolithografie und Ätzen erzeugt werden, was mehrere Prozessschritte erfordert.

Vor diesem Hintergrund besteht die Aufgabe der Erfindung darin, ein Verfahren anzugeben mit dem der Stand der Technik weitergebildet wird.

Die Aufgabe wird durch ein Verfahren zur Herstellung eines Via bei einer III-V Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand wird ein Verfahren zur Herstellung eines Via bei einer III-V Mehrfachsolarzelle bereitgestellt.

Die III-V Mehrfachsolarzelle weist eine Oberseite und eine Unterseite auf, wobei das Via von der Oberseite bis zur Unterseite durchgängig ausgebildet ist.

Die III-V Mehrfachsolarzelle umfasst ein an der Unterseite angeordnetes Substrat auf.

Das Substrat weist eine Oberseite und ein auf der Oberseite des Substrats ausgebildetes Epi-Schichtsystem mit mehreren III-V Schichten auf.

Das Epi-Schichtsystem umfasst wenigstens eine erste III-V Solarzelle. An der Oberseite der ersten III-V Solarzelle ist eine organische Schicht angeordnet.

In einem ersten Verfahrensschritt mittels eines Lasers eine Öffnung mit einer Weite X und mit einer in dem Epi-Schichtsystem ausgebildeten ersten Bodenfläche erzeugt wird.

In einem zweiten Verfahrensschritt mittels des Lasers eine Öffnung mit einer Weite Y und mit einer in dem Substrat ausgebildeten zweiten Bodenfläche erzeugt wird, wobei die Weite Y kleiner als die Weite X ist.

In einem dritten Verfahrensschritt mittels des Lasers zur Ausbildung des durchgehenden Vias eine Öffnung mit einer Weite Z erzeugt wird, wobei die Öffnung keine Bodenfläche aufweist und die Weite Z kleiner als die Weite Y ist.

Die vorgenannten Verfahrensschritte werden in der angegebenen Reihenfolge oder in einer beliebigen Reihenfolge ausgeführt.

Sofern die vorgenannten Verfahrensschritte in der angegebenen Reihenfolge ausgeführt werden, wird der zweite Verfahrensschritt nach dem ersten Verfahrensschritt und anschließend der dritte Verfahrensschritt ausgeführt. Hierbei versteht es sich, dass in dem zweiten Verfahrensschritt in der ersten Bodenfläche die Öffnung mit der zweiten Bodenfläche und in den dritten Verfahrensschritt in der zweiten Bodenfläche die als Via bezeichnete durchgehende Öffnung erzeugt wird.

Sofern die Verfahrenschritte nicht in der angegebenen Reihenfolge ausgeführt werden, wird der dritte Verfahrensschritt als erstes ausgeführt und anschließend entweder der zweite Verfahrensschritt oder der erste Verfahrensschritt als zweites ausgeführt.

Anschließend wird der noch nicht ausgeführte Verfahrensschritt d.h. der erste Verfahrensschritt oder der zweite Verfahrensschritt ausgeführt. Es versteht sich hierbei, dass je nach Reihenfolge die zweite Bodenfläche nach der durchgehenden Öffnung und im letzten Verfahrensschritt die erste Bodenfläche ausgebildet wird.

In einer anderen Weiterbildung wird der zweite Verfahrensschritt als erstes ausgeführt und hierbei die zweite Bodenfläche ausgebildet. Anschließend wird entweder der erste Verfahrensschritt mit Ausbildung der ersten Bodenfläche oder der dritte Verfahrensschritt mit Ausbildung der durchgehenden Öffnung ausgeführt. Anschließend wird der noch nicht ausgeführte Verfahrensschritt d.h. der dritte Verfahrensschritt oder der erste Verfahrensschritt ausgeführt.

Es versteht sich, dass nach der Durchführung aller drei Verfahrensschritte, unabhängig von der Reihenfolge deren Ausführung, immer eine Durchgangsöffnung mit zwei Stufen ausgebildet wird. Anders ausgedrückt, in einer Querschnittsansicht entsprechen die auf unterschiedlichen Wegen hergestellten Durchgangsöffnungen einander oder sind genau gleich aufgebaut.

Es sei angemerkt, dass die organische Schicht eine Lackschicht und / oder eine Polyimid Schicht und / oder eine Kunststoffschicht umfasst. Es versteht sich, dass die Schichten vorzugsweise unstrukturiert ausgebildet sind, um einen Maskenschritt zu vermeiden.

Des Weiteren sei angemerkt, dass es sich bei dem Via immer um eine durch die ganzen Schichten hindurchreichende senkrecht zu der Vorderseite ausgebildete Öffnung handelt. Derartige Öffnungen lassen sich für eine elektrische Durchkontaktierung verwenden, indem eine Metallschicht in dem Via ausgebildet wird.

Des Weiteren versteht es sich, dass es sich bei dem Substrat um ein Halbleitersubstrat bzw. als Halbleiterscheibe mit einem Durchmesser von wenigstens oder genau 100 mm oder wenigstens oder genau 150 mm handelt.

Auch sei angemerkt, dass alle Verfahrensschritte unter Verwendung eines Lasers ausgehend von der Oberseite aus durchgeführt werden.

Es sei angemerkt, dass vorliegend unter dem Begriff der dielektrischen Schicht ausschließlich anorganische Schichten, insbesondere Oxid und Nitridschichten, umfasst sind.

Es versteht sich, dass unter dem Begriff Epi-Schichtsystem ausschließlich auf dem Substrat mittels eines Epitaxie-Prozesses hergestellte III-V Schichten bezeichnet werden.

Des Weiteren sei angemerkt, dass die in dem Epi-Schichtsystem oder in dem Substrat ausgebildete erste Bodenfläche eine Öffnung bzw. ein Loch aufweist, sodass die erste Bodenfläche ausgehend von der Öffnung bzw. dem Loch als umlaufende Randfläche ausgebildet ist.

Es versteht sich, dass die in dem Bodenbereich ausgebildete Fläche, d.h. erste Bodenfläche bzw. umlaufende Randfläche plan ist oder in einer ersten Näherung plan ist und die Fläche am Boden bei dem Epi-Schichtsystem ausschließlich aus einem III-V Material oder bei der Bodenfläche in den Substrat ausschließliche aus dem Substratmaterial besteht.

Des Weiteren sei angemerkt, dass bei den laserbasierten Verfahrensschritten jeweils entstehenden Seitenflächen genau senkrecht oder nahezu senkrecht ausgebildet sind. Unter dem Begriff "nahezu senkrecht" wird eine Abweichung von der Senkrechten kleiner als 5° verstanden.

In einer Weiterbildung ist der Öffnungswinkel weniger als 20° oder weniger als 10°. Unter dem Öffnungswinkel wird hierbei der Winkel verstanden der gegen die Senkrechte geneigt ist, wobei die Neigung nach "außen" erfolgt, sodass der Gesamtwinkel mehr als 90° beträgt. Anders ausgedrückt, das Loch weist an der Oberseite, bei einer nicht senkrechten Ausführung einen größeren Durchmesser auf als im Bereich des Bodens, das Loch ist als konisch ausgebildet.

Ein Vorteil ist, dass sich mit dem Verfahren ohne weitere Strukturierung mittels aufwändigen und teuren Lithographieprozessen die organische Schichten, insbesondere Lackschichten, flexibel an beliebigen Stellen auf der Oberseite der III-V Mehrfachsolarzelle durchgehende Via anordnen lassen. Mit den Via lässt sich die Oberseite d.h. die Vorderseite der III-V Mehrfachsolarzelle von der Rückseite her elektrisch kontaktieren.

Ein weiterer Vorteil ist, dass das wenigstens dreistufige Laser-Verfahren überraschenderweise unempfindlich gegen eine nicht wesentliche Veränderung des Schichtbaus, insbesondere der Dicke und der Anzahl der III-V Schichten ist. Auch ist das Verfahren unempfindlich gegen die Änderung des Substratmaterials von Ge aus GaAs und vice versa. Nicht wesentliche Änderungen sind insbesondere eine Änderung der III-V Materialzusammensetzung und der Stöchiometrie und eine Veränderung der Gesamtschichtdicke um weniger als 20 µm.

Ein anderer Vorteil ist, dass auch bei einer wesentlichen Änderung der Substratdicke sich die Einstellungen des Lasers leicht ändern lassen. Eine wesentliche Änderung ist insbesondere eine Änderung der Dicke des Substrats um mindestens 50 µm oder um mindestens 100 µm.

Ein anderer Vorteil von laserbasierten Verfahrensschritten im Vergleich zu nasschemischen Verfahrensschritten ist, dass keine Unterätzung auftritt. Des Weiteren bedingen nasschemische Verfahrensschritte grundsätzlich eine strukturierte Aufbringung von Schutzlacken auf der Oberfläche und / oder auf Seitenflächen von herzustellenden insbesondere bei mehrfach stufigen Strukturen.

In einer Ausführungsform werden mittels Verwendung des Lasers die Laser-Verfahrensschritte ohne Zwischenschritte, wie Nassätzschritte oder Trockenätzschritte nacheinander ausgeführt.

Es versteht sich jedoch, dass in einer anderen Ausführungsform anstelle von den drei aufeinanderfolgenden Laserverfahrensschritten auch mehr als drei beispielsweise vier oder fünf Verfahrensschritte unter Verwendung des Lasers durchgeführt werden.

In einer anderen Ausführungsform, werden weitere Verfahrensschritte ohne Laser zwischen oder vor oder nach dem wenigstens dreistufigen Öffnungsverfahren durchgeführt.

In einer Weiterbildung ist zwischen dem Substrat und der ersten III-V Solarzelle wenigstens eine weitere III-V Solarzelle ausgebildet.

In einer Ausführungsform weist die erste III-V Solarzelle als oberste III-V Solarzelle eine größere Bandlücke oder eine gleich große Bandlücke auf wie die darunterliegenden III-V Solarzellen.

Um die stapelförmig angeordneten III-V Solarzellen elektrisch miteinander in Serie zu verschalten sind zwischen den beiden III-V Solarzellen mehrere Tunneldiodenschichten angeordnet.

In einer anderen Weiterbildung weisen die beiden III-V Solarzellen gleiche oder unterschiedliche Materialien auf. In einer Ausführungsform umfasst die oberste III-V Solarzelle eine InGaP Verbindung. In einer Weiterbildung ist die weitere III-V Solarzelle als zweite III-V Solarzelle ausgebildet und umfasst eine GaAs Verbindung oder einer InGaAs Verbindung.

In einer Ausführungsform umfasst das Substrat Ge oder GaAs oder besteht aus Ge oder GaAs. Es versteht sich, dass auf dem Substrat eine Vielzahl von III-V Schichten angeordnet werden. Vorzugsweise werden die Schichten mittels einer MOVPE Anlage epitaktisch aufgewachsen.

In einer anderen Ausführungsform ist in der Oberseite des Substrats oder an der Oberseite des Substrats eine Substratsolarzelle ausgebildet. Im Fall des GaAs Substrat ist die Substratsolarzelle eine III-V Solarzelle im Fall von Ge eine VI - Solarzelle.

Es sei angemerkt, dass bei der Ausbildung des Substrats als Ge-Substrat, das Ge- Substrat meist als p-Ge-Substrat ausgebildet ist und im Fall der Ausbildung einer n-Ge-Schicht für die Ausbildung der Gruppe VI-Solarzelle an der Oberfläche oder in der Oberfläche des p-Ge-Substrats die n-Schicht mittels Eindiffusion von Dotanten und nicht mittels einer Epitaxie erzeugt wird.

In einer Weiterbildung weist das Substrat eine Dicke in einem Bereich zwischen 80 µm um 850 µm auf. In einer anderen Weiterbildung liegt die Dicke des Substrats in einem Bereich zwischen 150 µm und 750 µm.

In einer Ausführungsform sind oberhalb der ersten III-V Solarzelle und unterhalb der organischen Schicht weitere Schichten ausgebildet sind.

In einer Weiterbildung liegt die Weite X in einem Bereich zwischen 5 µm und 5 mm oder in einem Bereich zwischen 50 µm und 1 mm.

In einer Weiterbildung liegt die Weite y in einem Bereich zwischen 5 µm und 5 mm oder in einem Bereich zwischen 50 µm und 1 mm.

In einer Ausführungsform liegt das Verhältnis der Weite X zu der Weite Y unterhalb eines Faktors 10 oder unterhalb eines Faktors 5. Anders ausgedrückt, zwar ist die Weite X immer größer als die Weite Y, jedoch ist die Weite X maximal 10 mal größer als die Weite Y oder maximal 5 mal größer als die Weite Y.

In einer anderen Ausführungsform liegt die Weite Z in einem Bereich von 1 µm bis 1 mm oder die Weite Z der Vias liegt in einem Bereich von 20 µm bis 0,5 mm.

In einer anderen Ausführungsform ist die organische Schicht als durchgehende, die gesamte Oberseite der ersten III-V Solarzelle bedeckende Schicht, d.h. unstrukturiert ausgebildet. Hierbei lässt sich die organische Schicht sowohl durch Aufschleudern oder durch ein anderes Beschichtungsverfahren aufbringen.

In einer Weiterbildung ist zwischen der ersten III-V Solarzelle und der organischen Schicht wenigstens eine III-V Schicht und / oder wenigstens eine dielektrische Schicht ausgebildet. In einer anderen Weiterbildung umfasst oder besteht die dielektrische Schicht aus SiO₂.

In einer anderen Weiterbildung ist zwischen der ersten III-V Solarzelle und der organischen Schicht eine Antireflexschicht ausgebildet.

In einer Ausführungsform ist auf der Oberseite der III-V Mehrfachsolarzelle vor dem ersten Verfahrensschritt in dem Bereich des Via zwischen der ersten III-V Solarzelle und der organischen Schicht eine Metallschicht angeordnet oder genau keine Metallschicht ausgebildet. Anders ausgedrückt, die Verfahrensschritte lassen sich unabhängig von der Ausbildung oder nicht Ausbildung einer Metallschicht an der Stelle des herzustellenden Via durchführen.

In einer anderen Ausführungsform weist das Via eine ovale Form auf. In einer Weiterbildung weist das Via eine kreisförmige Öffnung auf.

In einer Weiterbildung wird in dem Via in einer Richtung von der Oberseite hin zu der Unterseite er III-V Mehrfachsolarzelle während der Durchführung des Laserprozesses wenigstens zwei Stufe ausgebildet.

In einer anderen Weiterbildung wird nach der Durchführung der drei Verfahrensschritte mit dem Laser eine nasschemische Ätzung, insbesondere zur Reinigung der Oberflächen und der Seitenflächen durchgeführt.

In einer Weiterbildung ist, je nach verwendeter Ätzlösung und deren Anwendungsdauer ist nach der Ätzung nur noch eine von beiden Stufen sichtbar. Vorzugsweise wird der nasschemische Ätzschritt unmittelbar nach der Durchführung der drei Laser-Verfahrensschritte ausgeführt.

In einer Weiterbildung wird die Entfernung der organischen Schicht erst nach der Ausführung eines nasschemischen Ätzschrittes durchgeführt. Ein Vorteil ist, dass die Oberfläche durch die organische Schicht vor einem Ätzangriff geschützt wird.

In einer Ausführungsform wird bei dem Via in einer parallel zu der Unterseite ausgebildeten Ebene gesehen ein konstanter Durchmesser oder ein in einer ersten Näherung konstanter Durchmesser ausgebildet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittsansicht auf eine nicht bearbeitete Mehrfachsolerzellenstruktur,
- Figur 2a-c: Querschnittsansichten auf eine entstehende Vla-Struktur nach unterschiedlichen Laserverfahrensschritten,
- Figur 3: Querschnittsansicht auf ein Via nach einem Nassätzschritt.

In den nachfolgend dargestellten Querschnittsanschichten wird jeweils einen Ausschnitt aus einer Mehrfachsolarzellenstruktur MS als Teil einer ganzen Halbleiterscheibe gezeigt, wobei die Mehrfachzellenstruktur MS in einer gleichfalls nicht dargestellten Ausführungsform auch als eine Vielzahl von Mehrfachzellenstrukturen MS auf einer Halbleiterscheibe mit wenigstens 100 mm Durchmesser ausgebildet ist.

Die nachfolgenden Abbildungen zeigen außerdem ausschließlich eine Ausführungsform bei der die Verfahrensschritte eins bis drei in der angegebenen Reihenfolge durchgeführt werden, d.h. der erste Verfahrensschritt wird als Erstes der zweite Verfahrensschritt als Zweites und der dritte Verfahrensschritt als Drittes durchgeführt.

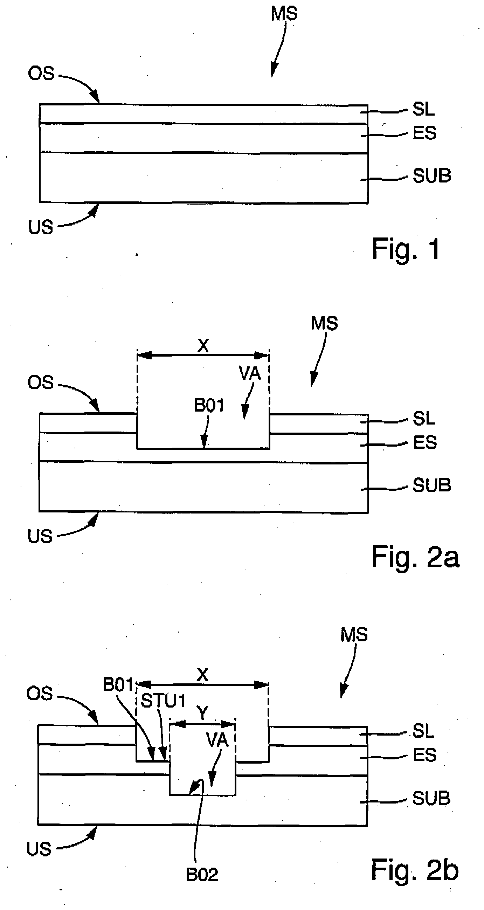

Die Abbildung der Figur 1 zeigt eine Querschnittsansicht auf die nicht bearbeitete Mehrfachsolarzellenstruktur MS mit einer Unterseite US und einer Oberseite OS. An der Unterseite US der Mehrfachsolarzellenstruktur MS ist eine Substratschicht SUB aus Germanium oder GaAs ausgebildet.

Auf einer Oberseite der Substratschicht SUB ist ein Epischichtsystem ES ausgebildet. Das Epi-Schichtsystem ES ist stoffschlüssig auf der Substratschicht SUB angeordnet. Auf dem Epi-Schichtsystem ES ist eine als Schutzlack ausgebildete, organische Schicht SL angeordnet.

Die organische Schicht SL ist in der dargestellten Ausführungsform stoffschlüssig mit der Oberseite des III-V Epi-Schichtsystem ES verbunden.

In der einer nicht dargestellten Ausführungsform ist oder sind zwischen dem Epi-Schichtsystem und der organische Schicht SL weitere Schichten, insbesondere Passivierungsschichten stoffschlüssig auf dem Epischichtsystem ES ausgebildet.

In einer nicht dargestellten Ausführungsform sind zwischen der organischen Schicht SL und dem Epischichtsystem ES weitere organische und / oder anorganische Schichten ausgebildet. Vorzugsweise umfassen oder bestehen die weiteren Schichten Passivierungsschichten aus beispielsweise einem Siliziumoxid und / oder einem Siliziumnitrid.

Es versteht sich, dass die vorgenannten Schichten in der vorgenannten Reihenfolge angeordnet sind. Auch sei angemerkt, dass alle vorgenannten Schichten jeweils ganzflächig ausgebildet sind.

In der Abbildung der Figur 2a bis 2c sind einzelne Querschnittsansichten auf eine entstehende Via-Struktur dargestellt, wobei jede einzelne der Abbildung die entstehende Via-Struktur nach der Durchführung eines der drei Laserverfahrensschritte zeigt. Im Folgenden werden nur die Unterschiede zu der Abbildung der Figur 1 erläutert.

In einem ersten Verfahrensschritt, dargestellt in der Fig. 2a wird mittels eines Lasers eine Öffnung mit einer Weite X durch die organische Schicht SL nd mit einer in dem Epi-Schichtsystem ausgebildeten ersten Bodenfläche BO1 erzeugt. Die entstehenden Seitenflächen sind nahezu senkrecht ausgebildet.

In einem zweiten Verfahrensschritt wird mittels des Lasers in der Bodenfläche eine Öffnung mit einer Weite Y und mit einer in dem Substrat ausgebildeten zweiten Bodenfläche BO2 erzeugt, wobei die Weite Y kleiner als die Weite X ist. Indem nur in einem Teil der ersten Bodenfläche BO1 des Epi-Schichtsystems ein Loch erzeugt wird, entsteht eine erste Stufe STU1. Auch sind die bei dem zweiten Verfahrensschritt entstehende Seitenflächen sind nahezu senkrecht.

In einem dritten Verfahrensschritt wird mittels des Lasers zur Ausbildung des durchgehenden Via VA eine Öffnung mit einer Weite Z erzeugt wird, wobei die Öffnung keine Bodenfläche aufweist und die Weite Z kleiner als die Weite Y ist. Indem nur in einem Teil der zweiten Bodenfläche BO2 des Epi-Schichtsystems ein Loch erzeugt wird, entsteht eine zweite Stufe STU2. Auch sind die bei dem dritten Verfahrensschritt entstehende Seitenflächen nahezu senkrecht.

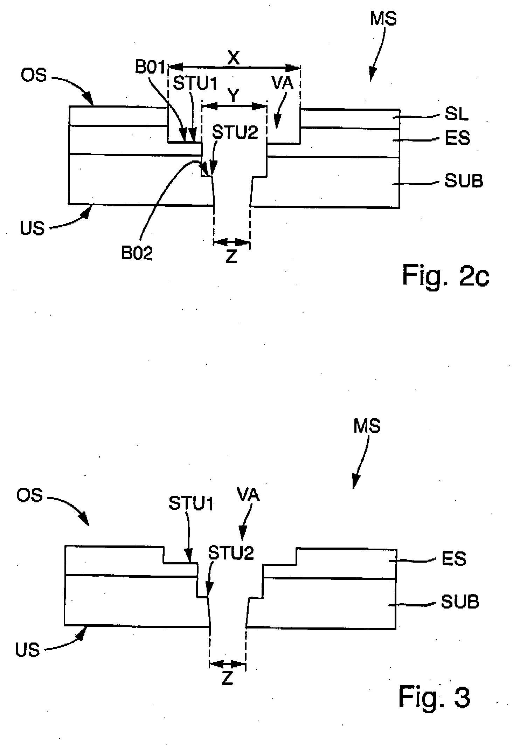

In der Abbildung Figur 3 ist ein Querschnittsansicht auf das Via, dargestellt in Zusammenhang mit der Abbildung der Figur 2c, nach einem Nassätzschritt dargestellt. Im Folgenden werden nur die Unterschiede zu der vorangegangenen Abbildung dargestellt.

Auf dem Epi-Schichtsystem ES ist die organische Schicht SL mittels eines Ablackprozess entfernt. Vorzugsweise vor dem Ablacken der organischen Schicht SL wurde ein Nassätzschritt durchgeführt, um die Seitenflächen in dem Via und die weiteren Flächen, insbesondere die Flächen der beiden Stufen STU1 und STU2 und die Seitenflächen von Verunreinigungen der drei Laserverfahrensschritte zu reinigen.

Bei dem Nassätzschritt wird die erste Stufe STU1 derart überformt, dass sich die Stufenfläche aus dem Epischichtsystem ES an die Grenzfläche Epischichtsystem ES und Oberseite des Substrats SUB verlegt. Auch wird die Tiefe der Fläche der ersten Stufe STU1 vergrößert. Auch nach der Durchführung des Ätzschritts sind die Seitenflächen innerhalb des Via VA nahezu senkrecht.

Auch wird die Stufenfläche der zweiten Stufe etwas tiefer in dem Substrat SUB verlegt.

Es versteht sich, dass in einer nicht dargestellten Ausführungsform die mittels des Lasers ausgeführten Verfahrensschritte auch in einer anderen Reihenfolge ausgeführt werden. Insbesondere lässt sich der zweite Verfahrensschritt vor dem ersten Verfahrensschritt ausführen.

## Patentansprüche

1. Verfahren zur Herstellung eines Via (VA) bei einer III-V Mehrfachsolarzelle (MS) mit einer Oberseite und einer Unterseite und das Via (VA) von der Oberseite (OS) bis zur Unterseite (US) durchgängig ausgebildet ist, und die III-V Mehrfachsolarzelle (MS) ein an der Unterseite (US) angeordnetes Substrat (SUB) umfasst, und das Substrat (SUB) eine Oberseite und ein auf der Oberseite ausgebildetes Epi-Schichtsystem (ES) mit mehreren III-V Schichten aufweist, und das Epi-Schichtsystem (ES) wenigstens eine erste III-V Solarzelle umfasst, und an der Oberseite der ersten III-V Solarzelle eine organische Schicht (SL) angeordnet ist,
- in einem ersten Verfahrensschritt mittels eines Lasers eine Öffnung mit einer Weite X und mit einer in dem Epi-Schichtsystem (ES) ausgebildeten ersten Bodenfläche (BO1) erzeugt wird,
- in einem zweiten Verfahrensschritt mittels des Lasers eine Öffnung mit einer Weite Y und mit einer in dem Substrat ausgebildeten zweiten Bodenfläche (BO2) erzeugt wird, wobei die Weite Y kleiner als die Weite X ist,
- in einem dritten Verfahrensschritt mittels des Lasers zur Ausbildung des durchgehenden Via (VA) eine Öffnung mit einer Weite Z erzeugt wird, wobei die Öffnung keine Bodenfläche aufweist und die Weite Z kleiner als die Weite Y ist,
- die vorgenannten Verfahrensschritte in der angegebenen Reihenfolge oder in einer beliebigen Reihenfolge ausgeführt werden.

2. Verfahren zur Herstellung eines Via (VA) bei einer III-V Mehrfachsolarzelle (MS) nach Anspruch 1, **dadurch gekennzeichnet, dass** zwischen dem Substrat und der ersten III-V Solarzelle wenigstens eine weitere III-V Solarzelle ausgebildet ist und zwischen den beiden III-V Solarzellen mehrere Tunneldiodenschichten angeordnet sind und die beiden III-V Solarzellen gleiche oder unterschiedliche Materialien aufweisen.

3. Verfahren zur Herstellung eines Via (VA) bei einer III-V Mehrfachsolarzelle (MS) nach Anspruch 1 oder Anspruch 2, **dadurch gekennzeichnet, dass** das Substrat (SUB) Ge oder GaAs umfasst oder aus Ge oder GaAs besteht.

4. Verfahren zur Herstellung eines Via bei einer III-V Mehrfachsolarzelle (MS) nach einem der vorangegangenen Ansprüche, **dadurch gekennzeichnet, dass** das Substrat (SUB) eine Dicke in einem Bereich zwischen 80 µm um 850 µm aufweist oder die Dicke des Substrats (SUB) in einem Bereich zwischen 150 µm und 750 µm liegt.

5. Verfahren zur Herstellung eines Via (VA) bei einer III-V Mehrfachsolarzelle (MS) nach einem der vorangegangenen Ansprüche, **dadurch gekennzeichnet, dass** oberhalb der ersten III-V Solarzelle und unterhalb der organischen Schicht (SL) weitere Schichten ausgebildet sind.

6. Verfahren zur Herstellung eines Via (VA) bei einer III-V Mehrfachsolarzelle (MS) nach einem der vorangegangenen Ansprüche, **dadurch gekennzeichnet, dass** die organische Schicht (SL) als durchgehende die gesamte Oberseite der ersten III-V Solarzelle bedeckende Schicht ausgebildet ist.

7. Verfahren zur Herstellung eines Via (VA) bei einer III-V Mehrfachsolarzelle (MS) nach einem der vorangegangenen. Ansprüche, **dadurch gekennzeichnet, dass** zwischen der ersten III-V Solarzelle und der organischen Schicht wenigstens eine III-V Schicht und / oder wenigstens eine dielektrische Schicht (SiO2) ausgebildet ist.

8. Verfahren zur Herstellung eines Via (VA) bei einer III-V Mehrfachsolarzelle (MS) nach einem der vorangegangenen Ansprüche, **dadurch gekennzeichnet, dass** zwischen der ersten III-V Solarzelle und der organischen Schicht eine Antireflexschicht ausgebildet ist.

9. Verfahren zur Herstellung eines Via bei einer III-V Mehrfachsolarzelle (MS) nach einem der vorangegangenen Ansprüche, **dadurch gekennzeichnet, dass** auf der Oberseite (OS) der III-V Mehrfachsolarzelle (MS) vor dem ersten Verfahrensschritt in dem Bereich des Via zwischen der ersten III-V Solarzelle und der organischen Schicht (SL) eine Metallschicht angeordnet oder keine Metallschicht ausgebildet ist.

10. Verfahren zur Herstellung eines Via (VA) bei einer III-V Mehrfachsolarzelle (MS) nach einem der vorangegangenen Ansprüche, **dadurch gekennzeichnet, dass** das Via eine ovale Form aufweist und in dem Via in einer Richtung von der Oberseite hin zu der Unterseite der III-V Mehrfachsolarzelle (MS) wenigstens eine erste Stufe (STU1) oder wenigstens zwei Stufen oder genau zwei Stufen ausgebildet werden.

11. Verfahren zur Herstellung eines Via (VA) bei einer III-V Mehrfachsolarzelle (MS) nach einem der vorangegangenen Ansprüche, **dadurch gekennzeichnet, dass** bei dem Via (VA) in einer parallel zu der Unterseite ausgebildeten Ebene gesehen ein konstanter Durchmesser oder ein in einer ersten Näherung konstanter Durchmesser ausgebildet wird.

## Claims

1. Method of producing a via (VA) in a III-V multi-junction solar cell (MS) with an upper side and a lower side and the via (VA) is formed to be continuous from the upper side (OS) to the lower side (US), and the III-V multi-junction solar cell (MS) comprises a substrate (SUB) arranged at the lower side (US), and the substrate (SUB) has an upper side and an epitaxial layer system (ES), which is formed on the upper side, with a plurality of III-V layers, and the epitaxial layer system (ES) comprises at least one first III-V solar cell and an organic layer (SL) is formed at the upper side of the first III-V solar cell,
- in a first method step an opening with a width X and with a first base surface (BO1) formed in the epitaxial layer system (ES) is produced by means of a laser,
- in a second method step an opening with a width Y and with a second base surface (BO2) formed in the substrate is produced by means of the laser, wherein the width Y is smaller than the width X,
- in a third method step an opening with a width Z is produced by means of the laser for formation of the continuous via (VA), wherein the opening has no base surface and the width Z is smaller than the width Y,
- the aforesaid method steps are executed in the indicated sequence or in a desired sequence.

2. Method of producing a via (VA) in a III-V multi-junction solar cell (MS) according to claim 1, **characterised in that** at least one further III-V solar cell is formed between the substrate and the first III-V solar cell and a plurality of tunnel diode layers is arranged between the two III-V solar cells and the two III-V solar cells comprise the same or different materials.

3. Method of producing a via (VA) in a III-V multi-junction solar cell (MS) according to claim 1 or claim 2, **characterised in that** the substrate (SUB) comprises Ge or GaAs or consists of Ge or GaAs.

4. Method of producing a via in a III-V multi-junction solar cell (MS) according to any one of the preceding claims, **characterised in that** the substrate (SUB) has a thickness in a range between 80 µm and 850 µm or the thickness of the substrate (SUB) lies in a range between 150 µm and 750 µm.

5. Method of producing a via (VA) in a III-V multi-junction solar cell (MS) according to any one of the preceding claims, **characterised in that** further layers are formed above the first III-V solar cell and below the organic layer (SL).

6. Method of producing a via (VA) in a III-V multi-junction solar cell (MS) according to any one of the preceding claims, **characterised in that** the organic layer (SL) is formed as a continuous layer covering the entire upper side of the first III-V solar cell.

7. Method of producing a via (VA) in a III-V multi-junction solar cell (MS) according to any one of the preceding claims, **characterised in that** at least one III-V layer and/or at least one dielectric layer (SiO2) is or are formed between the first III-V solar cell and the organic layer.

8. Method of producing a via (VA) in a III-V multi-junction solar cell (MS) according to any one of the preceding claims, **characterised in that** an anti-reflection layer is formed between the first III-V solar cell and the organic layer.

9. Method of producing a via (VA) in a III-V multi-junction solar cell (MS) according to any one of the preceding claims, **characterised in that** a metal layer is arranged or no metal layer is formed on the upper side (OS) of the III-V multi-junction solar cell (MS) in the region of the via between the first III-V solar cell and the organic layer (SL) prior to the first method step.

10. Method of producing a via (VA) in a III-V multi-junction solar cell (MS) according to any one of the preceding claims, **characterised in that** the via has an oval shape and at least one first step (STU1) or at least two steps or exactly two steps is or are formed in the via in a direction from the upper side to the lower side of the III-V multi-junction solar cell (MS).

11. Method of producing a via (VA) in a III-V multi-junction solar cell (MS) according to any one of the preceding claims, **characterised in that** in the case of the via (VA) a constant diameter or a diameter constant to a first approximation is formed as seen in a plane formed parallelly to the lower side.

## Revendications

1. Procédé destiné à fabriquer un trou d'interconnexion (VA) dans une cellule solaire multiple III-V (MS) avec une face supérieure et une face inférieure et le trou d'interconnexion (VA) est conçu de manière continue depuis la face supérieure (OS) jusqu'à la face inférieure (US) et la cellule solaire multiple III-V (MS) comprend un substrat (SUB) disposé sur la face inférieure (US), et le substrat (SUB) présente une face supérieure et un système de couches épitaxiales (ES) conçu sur la face supérieure avec plusieurs couches III-V, et le système de couches épitaxiales (ES) comprend au moins une première cellule solaire III-V, et sur la face supérieure de la première cellule solaire III-V est disposée une couche organique (SL),
- dans une première étape de procédé, on produit à l'aide d'un laser une ouverture avec une largeur X et avec une première surface de fond (BO1) conçue dans le système de couches épitaxiales (ES),
- dans une deuxième étape de procédé, on produit à l'aide du laser une ouverture avec une largeur Y et avec une seconde surface de fond (BO2) conçue dans le substrat, dans lequel la largeur Y est inférieure à la largeur X,
- dans une troisième étape de procédé, à l'aide du laser pour concevoir le trou d'interconnexion continu (VA), on produit une ouverture avec une largeur Z l'ouverture ne présentant aucune surface de fond et la largeur Z étant inférieure à la largeur Y,
- les étapes de procédé susmentionnées sont réalisées dans l'ordre indiqué ou dans un ordre quelconque.

2. Procédé de fabrication d'un trou d'interconnexion (VA) dans une cellule solaire multiple III-V (MS) selon la revendication 1, **caractérisé en ce que**, entre le substrat et la première cellule solaire III-V, au moins une autre cellule solaire III-V est conçue et, entre les deux cellules solaires III-V, plusieurs couches de diodes à effet tunnel sont disposées et les deux cellules solaires III-V présentent des matériaux identiques ou différents.

3. Procédé de fabrication d'un trou d'interconnexion (VA) dans une cellule solaire multiple III-V (MS) selon la revendication 1 ou la revendication 2, **caractérisé en ce que** le substrat (SUB) comprend du Ge ou GaAs ou est constitué de Ge ou GaAs.

4. Procédé de fabrication d'un trou d'interconnexion dans une cellule solaire multiple III-V (MS) selon une des revendications précédentes, **caractérisé en ce que** le substrat (SUB) présente une épaisseur dans une plage comprise entre 80 µm et 850 µm ou l'épaisseur du substrat (SUB) se situe dans une plage comprise entre 150 µm et 750 µm.

5. Procédé de fabrication d'un trou d'interconnexion (VA) dans une cellule solaire multiple III-V (MS) selon une des revendications précédentes, **caractérisé en ce que**, au-dessus de la première cellule solaire III-V et au-dessous de la couche organique (SL) d'autres couches sont conçues.

6. Procédé de fabrication d'un trou d'interconnexion (VA) dans une cellule solaire multiple III-V (MS) selon une des revendications précédentes, **caractérisé en ce que** la couche organique (SL) est conçue sous la forme d'une couche continue recouvrant toute la face supérieure de la première cellule solaire III-V.

7. Procédé de fabrication d'un trou d'interconnexion (VA) dans une cellule solaire multiple III-V (MS) selon une des revendications précédentes, **caractérisé en ce que**, entre la première cellule solaire III-V et la couche organique, est conçue au moins une couche III-V et/ou au moins une couche diélectrique (SiO2).

8. Procédé de fabrication d'un trou d'interconnexion (VA) dans une cellule solaire multiple III-V (MS) selon une des revendications précédentes, **caractérisé en ce que**, entre la première cellule solaire III-V et la couche organique, est conçue une couche antireflet.

9. Procédé de fabrication d'un trou d'interconnexion dans une cellule solaire multiple III-V (MS) selon une des revendications précédentes, **caractérisé en ce que**, sur la face supérieure (OS) de la cellule solaire multiple III-V (MS) avant la première étape de procédé, dans la zone du trou d'interconnexion entre la première cellule solaire III-V et la couche organique (SL), une couche métallique est disposée ou bien aucune couche métallique n'est conçue.

10. Procédé de fabrication d'un trou d'interconnexion (VA) dans une cellule solaire multiple III-V (MS) selon une des revendications précédentes, **caractérisé en ce que** le trou d'interconnexion présente une forme ovale et, dans le trou d'interconnexion, sont conçus dans une direction depuis la face supérieure jusque vers la face inférieure de la cellule solaire multiple III-V (MS) au moins un premier niveau (STU1) ou au moins deux niveaux ou exactement deux niveaux.

11. Procédé de fabrication d'un trou d'interconnexion (VA) dans une cellule solaire multiple III-V (MS) selon une des revendications précédentes, **caractérisé en ce que** dans le trou d'interconnexion (VA), en regardant dans un plan parallèle à la face inférieure, un diamètre constant ou bien un diamètre constant dans un première parallélisme est conçu.
